# EUROPEAN PATENT APPLICATION

(11) **EP 4 411 799 A1**
(43) Date of publication of application: **07.08.2024**
(21) Application number: 23192885.4
(22) Date of filing: 23.08.2023
(51) Int. Cl.: H01L 21/768, H01L 23/522, H01L 23/532

(54) **SEMICONDUCTOR DEVICE AND METHOD FOR MANUFACTURING THE SAME**

(30) Priority: 31.01.2023 KR 20230013242
(71) Applicant: Samsung Electronics Co., Ltd., Suwon-si, Gyeonggi-do 16677 (KR)
(72) Inventor: LEE, Sangbong, Suwon-si (KR); NAM, Seowoo, Suwon-si (KR); SEO, Sungho, Suwon-si (KR); KANG, Seokmyeong, Suwon-si (KR); CHOI, KyuHoon, Suwon-si (KR); HA, Seungseok, Suwon-si (KR)
(74) Representative: Marks & Clerk LLP

(57) **Abstract**

A semiconductor device includes: a first interlayer insulating layer (10) disposed on a substrate; a first conductive line (Ma1) disposed in the first interlayer insulating layer (10) and having a protrusion protruding above an upper side of the first interlayer insulating layer (10); an etch stop layer (30) disposed on the first interlayer insulating layer (10) and the first conductive line (Ma1); and a via (50) passing through the etch stop layer (30) and contacting the first conductive line (Ma1), wherein the etch stop layer (30) includes a first etch stop layer (31) having a curved shape in a cross-sectional view and a second etch stop layer (32) disposed on the first etch stop layer (31) and having a thickness variation.

## Description

### BACKGROUND

### 1. Technical Field

The present disclosure relates to a semiconductor device and a method for manufacturing the same.

### 2. Discussion of Related Art

Integrated circuits (IC) of semiconductor devices connect many elements such as transistors, resistors, or capacitors through a multilayer interconnecting structure. A typical multilayer interconnecting structure connects conductive lines (e.g., copper lines) on different layers through a via.

The multilayer interconnecting structure may be manufactured by repetitively performing a lithography process. A plurality of lithography processes may lead to defects such as overlay errors or critical dimension (CD) errors. These defects may be become more likely as semiconductor devices are scaled down with advances in integration.

With higher integration devices, gaps between the conductive lines become narrow, and an electrical short circuit margin between the via and an adjacent conductive line may be further reduced by a small misalignment between the via and the conductive line. These misalignments may be caused by the overlay errors or the CD errors, and reliability of the semiconductor device may be substantially reduced.

### SUMMARY

The present disclosure provides a semiconductor device with an increased electrical short circuit margin.

The present disclosure provides a method for manufacturing a semiconductor device with an increased electrical short circuit margin.

An embodiment of the present disclosure provides a semiconductor device including: a first interlayer insulating layer disposed on a substrate; a first conductive line disposed in the first interlayer insulating layer and having a protrusion protruding above an upper side of the first interlayer insulating layer; an etch stop layer disposed on the first interlayer insulating layer and the first conductive line; and a via passing through the etch stop layer and contacting the first conductive line, wherein the etch stop layer includes a first etch stop layer having a curved shape in a cross-sectional view and a second etch stop layer disposed on the first etch stop layer and having a thickness variation.

The protrusion of the first conductive line may have a height between about 1 to 10 nm above the upper side of the first interlayer insulating layer.

A height of the first etch stop layer gradually increases toward a central portion of the first conductive line.

The first etch stop layer may have a radius of curvature of about 8 to 48 nm.

A thickness of the first etch stop layer at an apex may be about 0.5 to 4 nm from an upper side of the first conductive line.

An average thickness of the second etch stop layer may be greater than an average thickness of the first etch stop layer.

A first portion of the second etch stop layer overlapping the first interlayer insulating layer in a direction that is perpendicular to the substrate may be thicker than a second portion of the second etch stop layer overlapping the first conductive line in the direction that is perpendicular to the substrate.

An average thickness of the second portion of the second etch stop layer may be about 0.5 to 5 nm.

An average thickness of the first portion of the second etch stop layer may be about 1.5 to 8 nm.

The via may not pass through a portion of the first etch stop layer overlapping the first interlayer insulating layer in the direction that is perpendicular to the substrate.

The via may be disposed above and may not pass through the portion of the first etch stop layer overlapping the first interlayer insulating layer in the direction that is perpendicular to the substrate.

Another embodiment of the present disclosure provides a semiconductor device including: a first interlayer insulating layer; a plurality of lower conductive lines spaced from each other by the first interlayer insulating layer; an etch stop layer disposed on the first interlayer insulating layer and a first lower conductive line of the lower conductive lines; a second interlayer insulating layer disposed on the etch stop layer; a via passing through the second interlayer insulating layer and the etch stop layer and contacting the first lower conductive line; and an upper conductive line disposed on the via, wherein the first lower conductive line may have a protrusion protruding above an upper side of the first interlayer insulating layer, the etch stop layer may include a first etch stop layer in a curved shape in a cross-sectional view and a second etch stop layer disposed on the first etch stop layer and having a thickness variation, and a portion of the via may be disposed above and may not pass through a portion of the first etch stop layer overlapping the first interlayer insulating layer between the plurality of lower conductive lines.

Another embodiment of the present disclosure provides a method for manufacturing a semiconductor device including: forming a first conductive line in a first interlayer insulating layer; recessing the first interlayer insulating layer to form a protrusion of the first conductive line protruding above an upper side of the first interlayer insulating layer; forming a first etch stop layer in a curved shape to cover the first interlayer insulating layer and the protrusion of the first conductive line; forming a second etch stop layer with a thickness variation on the first etch stop layer; and forming a via passing through the first etch stop layer and second etch stop layer.

The recessing of the first interlayer insulating layer may include recessing the first interlayer insulating layer by a reactive ion etching process.

The first etch stop layer may be formed by a chemical vapor deposition process, a physical vapor deposition sputtering process, or a selective deposition process.

The method may further include forming a second interlayer insulating layer on the second etch stop layer.

The forming of the via may include etching the second etch stop layer; and a top corner rounding process for rounding a corner of the second interlayer insulating layer.

The forming of the second etch stop layer may include forming a first portion of the second etch stop layer overlapping the first interlayer insulating layer and a second portion of the second etch stop layer overlapping the first conductive line, wherein the first portion is thicker than the second portion.

The forming of the via may include ending a process for etching the second etch stop layer when the second portion of the second etch stop layer overlapping the first conductive line is etched and the first etch stop layer is exposed.

The forming of the via may include ending a process for etching the second etch stop layer while at least a portion of the first portion of the second etch stop layer overlapping the first interlayer insulating layer and disposed below the via remains when the second portion of the second etch stop layer overlapping the first conductive line in the direction that is perpendicular to the substrate is etched and the first etch stop layer is exposed.

A semiconductor device according to an embodiment may efficiently prevent or slow the generation of a time dependent dielectric breakdown (TDDB) degradation. The TDDB may be prevented or slowed by increasing an electrical short circuit margin. With an increased electrical short circuit margin, an edge placement error (EPE) of the via generated due to an overlay error or a critical dimension (CD) error of the lithography process may be less likely to result in an electrical short circuit. Further, the overlay and the CD margin of the lithography process may be increased by increasing the electrical short circuit margin.

At least some of the above and other features of the invention are set out in the claims.

### BRIEF DESCRIPTION OF THE DRAWINGS

FIG. 1 shows a top plan view of a correctly aligned via and a conductive line in a semiconductor device according to embodiments.
FIG. 2 shows a cross-sectional diagram with respect to a line A-A' of FIG. 1.
FIG. 3 shows a cross-sectional diagram with respect to a line B-B' of FIG. 1.
FIG. 4 shows a top plan view of a misaligned via and a conductive line in a semiconductor device according to embodiments.
FIG. 5 shows a cross-sectional view with respect to a line A-A' of FIG. 4, and shows misaligned vias and conductive lines according to embodiments.
FIG. 6 shows a cross-sectional view with respect to a line A-A' of FIG. 4, and shows misaligned vias and conductive lines according to embodiments.
FIG. 7, FIG. 8, FIG. 9, FIG. 10, FIG. 11, FIG. 12, FIG. 13, FIG. 14, FIG. 15, FIG. 16, FIG. 17, FIG. 18, FIG. 19, FIG. 20, and FIG. 21 show cross-sectional views on a method for manufacturing a semiconductor device according to embodiments.

### DETAILED DESCRIPTION

In the following detailed description, embodiments of the present disclosure have been shown and described by way of illustration. As those skilled in the art would realize, embodiments may be modified in various ways without departing from the scope of the present disclosure.

Accordingly, the drawings and description are to be regarded as illustrative in nature and not restrictive, and like reference numerals designate like elements throughout the specification.

An expression recited in the singular may be construed as singular or plural unless the expression "one", "single", etc. is used. Terms including ordinal numbers such as first, second, and the like, may be used only to describe various components, and are not interpreted as limiting these components. The terms are only used to differentiate one component from other components.

Hereinafter, embodiments of the present disclosure will be described with reference to accompanying drawings.

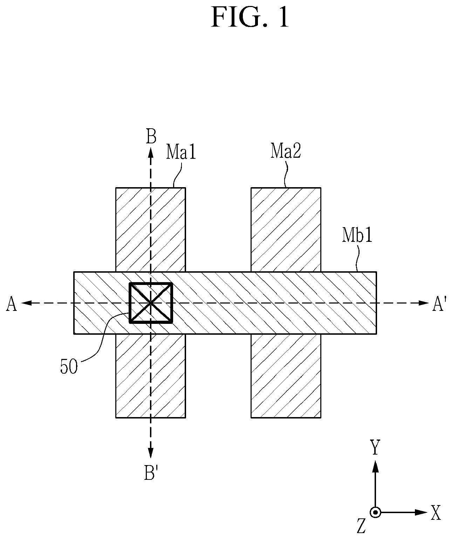

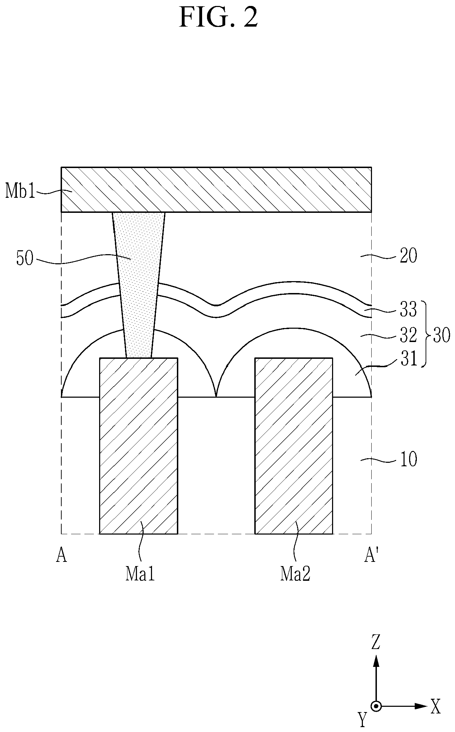

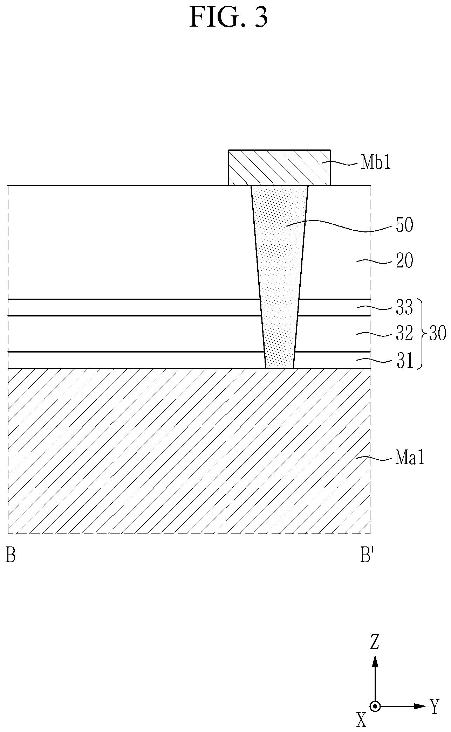

FIG. 1 shows a top plan view of an aligned via and a conductive line in a semiconductor device according to embodiments. A substrate (not shown) may extend in a first direction (X direction) and a second direction (Y direction). FIG. 2 shows a cross-sectional diagram with respect to a line A-A' of FIG. 1. FIG. 3 shows a cross-sectional diagram with respect to a line B-B' of FIG. 1.

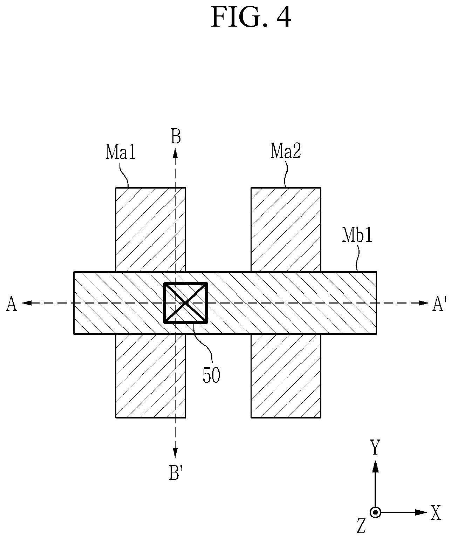

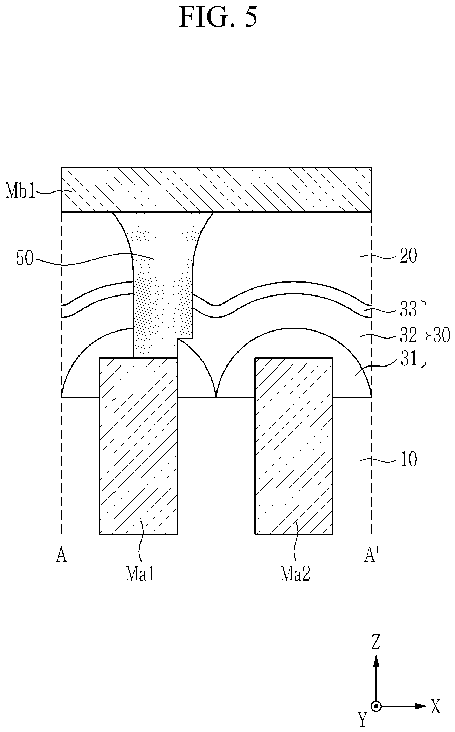

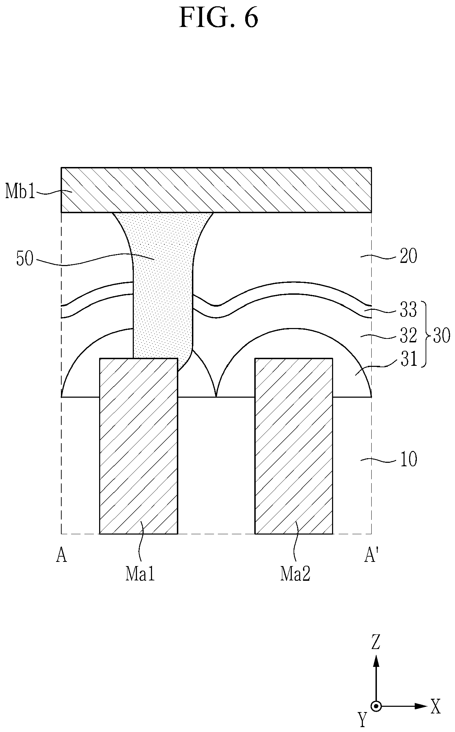

FIG. 4 shows a top plan view of a misaligned via and a conductive line in a semiconductor device according to embodiments. FIG. 5 and FIG. 6 show cross-sectional views with respect to a line A-A' of FIG. 4. FIG. 5 and FIG. 6 show misaligned vias and conductive lines according to other embodiments.

FIG. 1 and FIG. 4 omit illustration of a first interlayer insulating layer 10, a second interlayer insulating layer 20, and an etch stop layer 30.

Referring to FIG. 1, FIG. 2, and FIG. 3, the semiconductor device according to embodiments may include a first lower conductive line Ma1, a second lower conductive line Ma2, an etch stop layer 30, a via 50 passing through the etch stop layer 30 and connected to one of the first lower conductive line Ma1 and the second lower conductive line Ma2, and an upper conductive line Mb1 disposed on the via 50.

Referring to FIG. 1, the first lower conductive line Ma1 and the second lower conductive line Ma2 may extend in a Y direction. The first lower conductive line Ma1 and the second lower conductive line Ma2 may extend in parallel in the Y direction parallel. The upper conductive line Mb1 may extend in an X direction. The upper conductive line Mb1 may overlap the second lower conductive line Ma1 and the second lower conductive line Ma2 in a direction (Z direction) that is perpendicular to the substrate (not shown) extending in the X-Y directions.

The via 50 may be disposed on a portion of the first lower conductive line Ma1 and second lower conductive line Ma2 overlapped by the upper conductive line Mb1 in the direction (Z direction).

Referring to FIG. 2, the via 50 may electrically connect the first lower conductive line Ma1 and the upper conductive line Mb1. The first lower conductive line Ma1 and the second lower conductive line Ma2 may be spaced from each other in the X direction by a first interlayer insulating layer 10 disposed on the substrate (nor shown).

The substrate may include a semiconductor material such as silicon, germanium, or silicon-germanium, or a Group III-V compound such as gallium phosphide (GaP), gallium arsenide (GaAs), or gallium antimonide (GaSb). According to some embodiments, the substrate may be a silicon-on-insulator (SOI) substrate or a germanium-on-insulator (GOI) substrate.

Although not shown, various types of elements, for example, a gate structure, source/drain layers, and a contact plug may be disposed on the substrate, and these elements may be covered by an insulation layer disposed between the substrate and the first interlayer insulating layer 10.

In some embodiments, sidewalls and bottom sides of the first lower conductive line Ma1 and the second lower conductive line Ma2 may be covered by the first interlayer insulating layer 10. In other embodiments, the first lower conductive line Ma1 and the second lower conductive line Ma2 may pass through the first interlayer insulating layer 10. In this case, the first lower conductive line Ma1 and the second lower conductive line Ma2 may be electrically connected to elements disposed on a lower portion of the first interlayer insulating layer 10.

The first interlayer insulating layer 10 may, for example, include at least one of a low dielectric constant (low-K) dielectric material such as a tetraethyl orthosilicate (TEOS) oxide; silicate glass that is not doped; borophosphosilicate glass (BPSG); phosphosilicate glass (PSG); fusing silica glass (FSG); boron doped silicon glass (BSG); a doped silicon oxide such as SiOF or SiOCH; a porous silicon oxide; an inorganic polymer such as hydrogen silsesquioxane (HSSQ) or methyl silsesquioxane (MSSQ); or a spin on organic polymer.

The first lower conductive line Ma1 and the second lower conductive line Ma2 may include a first barrier metal pattern (not shown) and a first metal pattern (not shown). In detail, the first lower conductive line Ma1 and the second lower conductive line Ma2 may include a first metal pattern and a first barrier metal pattern. The first barrier metal pattern may cover sidewalls and a bottom side of the first metal pattern.

The first barrier metal pattern may, for example, include at least one nitride or oxide selected from among a tantalum nitride (TaN), a titanium nitride (TiN), a tantalum oxide (TaO), a titanium oxide (TiO), a manganese nitride (MnN), or a manganese oxide (MnO). The first metal pattern may, for example, include at least one of copper (Cu), aluminum (Al), ruthenium (Ru), cobalt (Co), tungsten (W), molybdenum (Mo), platinum (Pt), iridium (Ir), rhodium (Rh), an aluminum binary alloy (e.g., Al₃Sc, Nb₃Al, and RuAl), a Mo binary alloy (e.g., MoTa and Co₃Mo), a Ru binary alloy (e.g., RuAl), a Ni binary alloy (e.g., NiAl), or a MAX material. The MAX material may exhibit a combination of metallic and ceramic properties. The MAX material may be expressed as Mₙ₊₁AXₙ, where n is 1, 2 or 3, M is a transition metal, A is an element of Group 13 or Group 14, and X is C and/or N. For example, the MAX material may be V₂SiN, V₂AlC, or Cr₂AlC.

In some embodiments, a first metal capping pattern may be additionally disposed on an upper side of the first metal pattern. The first metal capping pattern may be thin and uniform. The first metal capping pattern may include, for example, ruthenium (Ru), cobalt (Co), or graphene.

Referring to FIG. 2, the first lower conductive line Ma1 and second lower conductive line Ma2 may have a portion that protrudes above an upper surface of the first interlayer insulating layer 10. The second lower conductive line Ma2 may have a portion that protrudes above the upper surface of the first interlayer insulating layer 10. The protrusion of the first lower conductive line Ma1 and the protrusion of the second lower conductive line Ma2 are described herein.

The etch stop layer 30 may cover the protrusion of the first lower conductive line Ma1 and the protrusion of the second lower conductive line Ma2. The etch stop layer 30 may include at least two etch stop layers. In detail, the etch stop layer 30 may include a first etch stop layer 31 and a second etch stop layer 32 disposed on the first etch stop layer 31. The first etch stop layer 31 may have a curved shape. The first etch stop layer 31 may have a thickness variation.

As shown in FIG. 2, the etch stop layer 30 may include the first etch stop layer 31 covering the protrusions of the first lower conductive line Ma1 and the second lower conductive line Ma2 and has a curved shape. The second etch stop layer 32 may be disposed on the first etch stop layer 31 and has a thickness variation. A third etch stop layer 33 may be disposed on the second etch stop layer 32.

The first etch stop layer 31 may both be a high dielectric layer and a low-density layer. The first etch stop layer 31 may, for example, include an oxide or a nitride containing at least one of Al, Zr, Y, Hf, or Mo. For example, the first etch stop layer 31 may include an aluminum oxide, a hafnium oxide, a hafnium zirconium oxide, an aluminum nitride, a hafnium nitride, or a hafnium zirconium nitride, but is not limited thereto.

The second etch stop layer 32 may be both a low dielectric layer and a high-density layer. The dielectric constant of the second etch stop layer 32 may be less than the dielectric constant of the first etch stop layer 31. The density of the second etch stop layer 32 may be greater than the density of the first etch stop layer 31.

The second etch stop layer 32 may contain X, Y, and carbon (C). The X may be selected from among Si, Ge, Al, Zr, Y, Hf, or Mo, and the Y is O or N. For example, the second etch stop layer 32 may include SiOC, SiNC, GeOC, or GeNC, but is not limited thereto.

The third etch stop layer 33 may include an oxide containing, for example, at least one of Al, Zr, Y, Hf or Mo. For example, the third etch stop layer 33 may include an aluminum oxide. In some embodiments, the third etch stop layer 33 may include a same material as the first etch stop layer 31. In other embodiments, the third etch stop layer 33 may include a different material than the first etch stop layer 31. The dielectric constant of the third etch stop layer 33 may be greater than the dielectric constant of the second etch stop layer 32. The density of the third etch stop layer 33 may be less than the density of the second etch stop layer 32.

While the third etch stop layer 33 is shown in the drawing, the third etch stop layer 33 may be omitted in some embodiments.

The second interlayer insulating layer 20 may be disposed on the etch stop layer 30. The second interlayer insulating layer 20 may, for example, include at least one of a low dielectric constant (low-K) dielectric material such as a tetraethyl orthosilicate (TEOS) oxide; silicate glass that is not doped; borophosphosilicate glass (BPSG); phosphosilicate glass (PSG); fusing silica glass (FSG); boron doped silicon glass (BSG); a doped silicon oxide such as SiOF or SiOCH; a porous silicon oxide; an inorganic polymer such as hydrogen silsesquioxane (HSSQ) or methyl silsesquioxane (MSSQ); or a spin on organic polymer.

The via 50 may pass through the second interlayer insulating layer 20 and the etch stop layer 30. The via 50 may be connected to the first lower conductive line Ma1first lower conductive line Ma1 and second lower conductive line Ma2. The upper conductive line Mb1 may be disposed on the via 50. The via 50 and the upper conductive line Mb1 may, for example, be simultaneously formed by a dual damascene process. That is, the via 50 and the upper conductive line Mb1 may be integrally formed.

Referring to FIG. 2 and FIG. 3, the via 50 may pass through the second interlayer insulating layer 20 and the etch stop layer 30 and contacts an upper side of the first lower conductive line Ma1. The via 50 may further contact the upper conductive line Mb1. The upper conductive line Mb1 may pass through an upper portion of the second interlayer insulating layer 20 and may be connected to the via 50. The via 50 and the upper conductive line Mb1 may include a second metal pattern and a second barrier metal pattern for covering the second metal pattern.

The second barrier metal pattern may, for example, include at least one nitride or oxide selected from among a tantalum nitride (TaN), a titanium nitride (TiN), a tantalum oxide (TaO), a titanium oxide (TiO), a manganese nitride (MnN), or a manganese oxide (MnO). The second metal pattern may, for example, include at least one of copper (Cu), aluminum (Al), ruthenium (Ru), cobalt (Co), tungsten (W), molybdenum (Mo), platinum (Pt), iridium (Ir), rhodium (Rh), an aluminum binary alloy (e.g., Al₃Sc, Nb₃Al, and RuAl), a Mo binary alloy (e.g., MoTa and Co₃Mo), a Ru binary alloy (e.g., RuAl), a Ni binary alloy (e.g., NiAl), or a MAX material. The MAX material may exhibit a combination of metallic and ceramic properties. The MAX material may be expressed as Mₙ₊₁AXₙ, where n is 1, 2 or 3, M is a transition metal, A is an element of Group 13 or Group 14, and X is C and/or N. For example, the MAX material may be V₂SiN, V₂AlC, or Cr₂AlC.

In some embodiments, a second metal capping pattern may be additionally disposed on an upper side of the second metal pattern. The second metal capping pattern may be thin and uniform. The second metal capping pattern may include, for example, ruthenium (Ru), cobalt (Co), or graphene.

A semiconductor device according to some embodiments may efficiently prevent or slow the generation of a time dependent dielectric breakdown (TDDB) degradation. The TDDB may be prevented or slowed by increasing an electrical short circuit margin. With an increased electrical short circuit margin, an edge placement error (EPE) of the via generated due to an overlay error or the critical dimension (CD) error of the lithography process may be less likely to result in an electrical short circuit. Further, according to some embodiments, the overlays and the CD margins of the lithography process may be increased by increasing the electrical short circuit margin.

FIG. 4 shows the via 50, which is misaligned, and the first lower conductive line Ma1 that may be generated in some embodiments.

As described above, as the via 50 and the upper conductive line Mb1 may be integrally formed, the cross-sectional diagram with respect to a line B-B' of FIG. 4 may correspond to the cross-sectional diagram of FIG. 3. That is, even when the via 50 is misaligned with the first lower conductive line Ma1 in a first direction (X direction) in which the upper conductive line Mb1 extends, the via 50 may be correctly aligned with the upper conductive line Mb1.

Referring to FIG. 5, the second etch stop layer 32 may have a thickness that varies according to a profile of the first etch stop layer 31, which has a curved shape. For example, a thickness of a first portion of the second etch stop layer 32 overlapping the first interlayer insulating layer 10 in the direction (Z direction) that is perpendicular to the substrate may be greater than a thickness of a second portion of the second etch stop layer 32 overlapping the first lower conductive line Ma1 and the second lower conductive line Ma2 in the direction (Z direction) that is perpendicular to the substrate. Further, a thickest portion of the second etch stop layer 32 may be disposed above a portion where two curved shapes of the first etch stop layer 31 come together having a thin thickness. Stated another way, the thickest portion of the second etch stop layer 32 may be disposed between the protrusions of the first lower conductive line Ma1 and the second lower conductive line Ma2.

In embodiments, an average thickness of the first portion of the second etch stop layer 32 may, for example, be in the range of about 1.5 to 8 nm (nanometers). An average thickness of the second portion of the second etch stop layer 32 may, for example, be in the range of about 0.5 to 5 nm. Unless specifically limited in the present specification, the average thickness may be an arithmetic average of a thickest measure and a thinnest measure of a corresponding portion. The average thickness of the first portion of the second etch stop layer 32 may be greater than the average thickness of the second portion of the second etch stop layer 32.

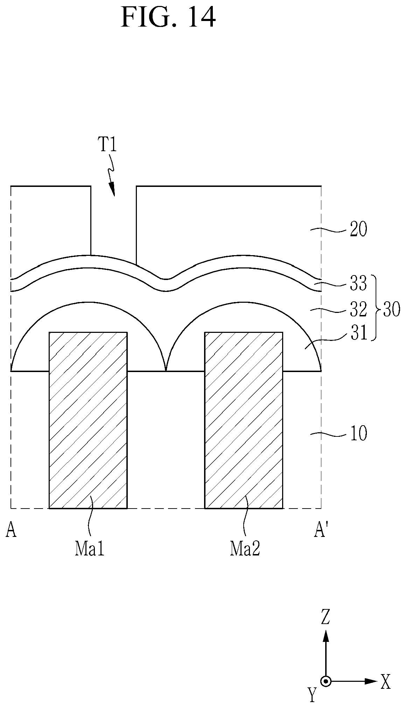

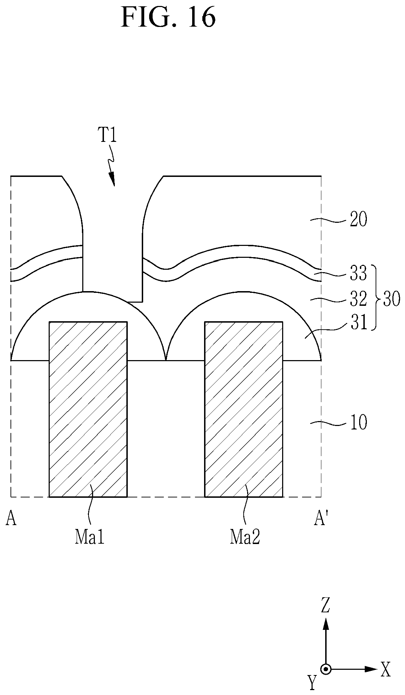

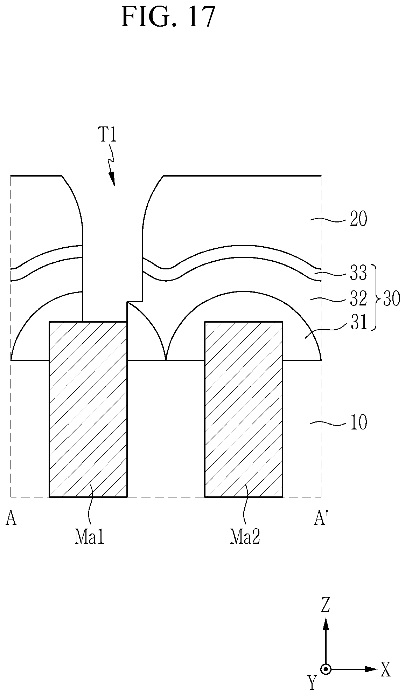

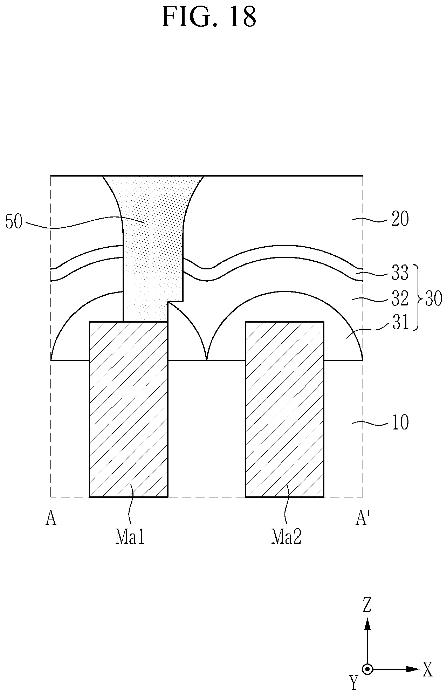

Hence, for a process in which a misaligned via hole (marked as T1 in FIG. 14) passes through the second etch stop layer 32 and extends to the first etch stop layer 31 (refer to FIG. 16), when a thin second portion (i.e., a portion of the second etch stop layer 32 on the first lower conductive line Ma1) is etched and the first etch stop layer 31 is exposed, an etching process of the second etch stop layer may end. As a result, a thick first portion (i.e., a portion of the second etch stop layer 32 on the first interlayer insulating layer 10) of the second etch stop layer 32 remains on the first etch stop layer 31. While the second etch stop layer 32 disposed on the first lower conductive line Ma1 is etched and the first etch stop layer 31 is exposed, the second etch stop layer 32 disposed on the first interlayer insulating layer 10 is not etched and remains on the first etch stop layer 31, which may be referred to as a partial etch of the second etch stop layer 32. After the second etch stop layer 32 is partially etched, the first etch stop layer 31 may be etched and the misaligned via hole T1 may extend to an upper side (refer to FIG. 17) of the first lower conductive line Ma1. A via 50 may be formed in the via hole T1 (refer to FIG. 18).

Referring to FIG. 5, the upper side of the first etch stop layer 31 overlapping the first interlayer insulating layer 10 in the direction (Z direction) that is perpendicular to the substrate may be covered by the second etch stop layer 32. In some embodiments, a whole of upper side of the first etch stop layer 31 overlapping the first interlayer insulating layer 10 in the direction (Z direction) that is perpendicular to the substrate may be covered by the second etch stop layer 32.

By the first portion of the second etch stop layer 32 remaining on the first etch stop layer 31 overlapping the first interlayer insulating layer 10 in the direction (Z direction) that is perpendicular to the substrate, the via 50 may be formed and may be self-aligned toward the first lower conductive line Ma1, and a distance between the via 50 and the second lower conductive line Ma2 may be increased to thus increase the electrical short circuit margin.

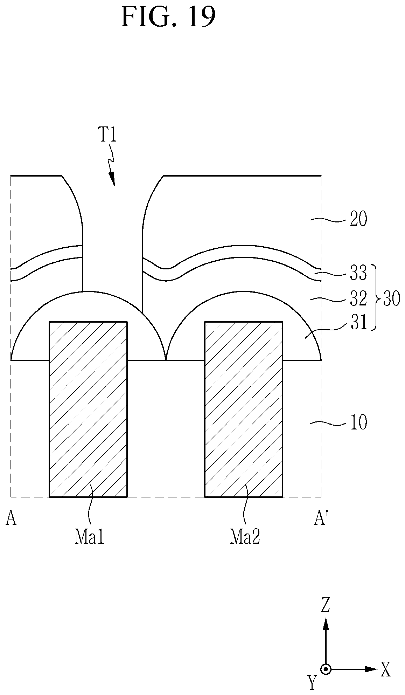

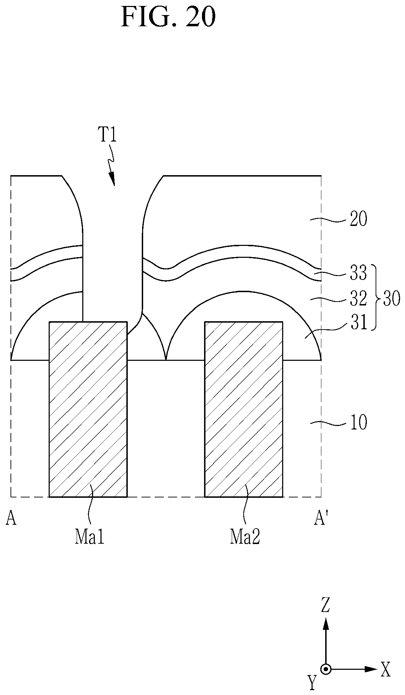

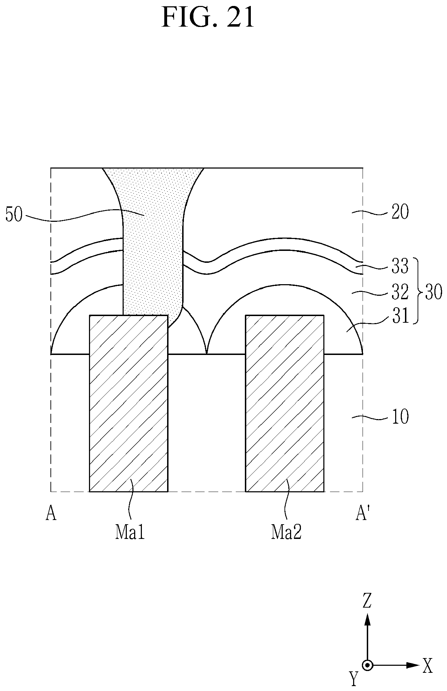

Referring to FIG. 19, in some embodiments, the first etch stop layer 31 may be exposed through the thin second portion of the second etch stop layer 32 by the process of etching the second etch stop layer 32. In this case, the via hole T1 exposes the upper side of the first lower conductive line Ma1 and does not expose the first interlayer insulating layer 10 (see Fig. 20). The thickness variation of the first etch stop layer 31 (refer to FIG. 20) may ensure that the via hole T1 exposes the upper side of the first lower conductive line Ma1 and does not expose the first interlayer insulating layer 10. Therefore, when the via 50 is formed in the via hole T1 as shown in FIG. 21, the via 50 may not pass through a portion of the first etch stop layer 31 overlapping the first interlayer insulating layer 10 in the direction (Z direction) that is perpendicular to the substrate as shown in FIG. 6. That is, in this case, the via 50 does not contact the first interlayer insulating layer 10 and may be self-aligned toward the first lower conductive line Ma1. In this case, the distance between the via 50 and the second lower conductive line Ma2 disposed near the via 50 may be increased, thereby increasing the electrical short circuit margin.

The thickness variation of the second etch stop layer 32, which may increase the electrical short circuit margin, may be induced from the curved shape of the first etch stop layer 31. For example, a selective etching of the first etch stop layer 31, where the second etch stop layer 32 may be not etched, see FIG. 16 and FIG. 17, may self-align a bottom portion of the via hole T1. The self-aligned bottom portion of the via hole T1 may have an increased the electrical short circuit margin to the second lower conductive line Ma2.

The curved shape of the first etch stop layer 31 may be formed such that a height of the first etch stop layer 31 may gradually increase and may then gradually decrease in a direction of one protruding sidewall to another protruding sidewall of the first lower conductive line Ma1 and the second lower conductive line Ma2. The curved shape of the first etch stop layer 31 may be formed such that an apex of the first etch stop layer 31 may be formed at a central portion of the first lower conductive line Ma1 and the second lower conductive line Ma2, and a thickness of the first etch stop layer 31 may gradually decrease towards the sidewalls of the first lower conductive line Ma1 and the second lower conductive line Ma2. The height of the first etch stop layer 31 may be the distance to the upper side of the first etch stop layer 31 from the upper sides of the first lower conductive line Ma1 and the second lower conductive line Ma2 in the direction (Z direction) that is perpendicular to the substrate.

The first etch stop layer 31 may have a curved shape with a radius of curvature of between about 8 to 48 nm.

As the first etch stop layer 31 has the radius of curvature in the range between about 8 to 48 nm, the second etch stop layer 32 having the thickness variation may be formed, and the effect of increasing the electrical short circuit margin may result from the partial etching on the second etch stop layer 32.

The thickness of the first etch stop layer 31 is factor for determining the shape of the first etch stop layer 31.

The thickness of the first etch stop layer 31 at the apex may, for example, be about 0.5 to 4 nm. The thickness of the first etch stop layer 31 at the apex may signify the longest distance to the upper side of the first etch stop layer 31 from the upper side of the first lower conductive line Ma1 and the second lower conductive line Ma2 in the direction (Z direction) that is perpendicular to the substrate. The thickness of the first etch stop layer 31 at the apex may have a greatest height from the upper side of the first interlayer insulating layer 10 in the direction (Z direction) that is perpendicular to the substrate.

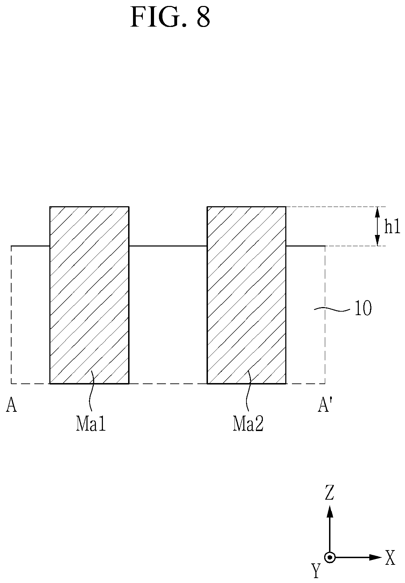

The height (marked as h1 in FIG. 8) of the first lower conductive line Ma1 and the second lower conductive line Ma2 protruding from the first interlayer insulating layer 10 is one factor for determining whether the etch stop layer 30 effects the electrical short circuit margin. The height (marked as h1 in FIG. 8) of the first lower conductive line Ma1 and the second lower conductive line Ma2 protruding from the first interlayer insulating layer 10 is one factor for determining a degree of an effect of the etch stop layer 30 on the electrical short circuit margin. When the height h1 is low, it may be difficult for the first etch stop layer 31 to have a curved shape. As a result, the second etch stop layer 32 disposed on the first etch stop layer 31 may not have a target thickness variation. Hence, when the misaligned via hole T1 passes through the second etch stop layer 32 and extends to the upper side of the first etch stop layer 31, the second etch stop layer 32 may not be properly partially etched and the electrical short circuit margin may not be increased. When the height h1 is high, a ratio of a gap between the first lower conductive line Ma1 and the second lower conductive line Ma2 to the height h1 may become low.

According to an embodiment, the height h1 of the first lower conductive line Ma1 and the second lower conductive line Ma2 protruding from the first interlayer insulating layer 10 may be about 1 to 10 nm. Within the range of about 1 to 10 nm, the electrical short circuit margin may be increased, thereby increasing a reliability of the semiconductor device.

The via 50 may have a width that is reduced near the first lower conductive line Ma1 from the upper conductive line Mb1. The via 50 may have a first width at a top portion and a second width at a bottom portion, wherein the first width is greater than the second width. The via 50 may have a step between the top portion and the bottom portion.

Referring to FIG. 2, FIG. 3, and FIG. 12, the sidewall of the via 50 is shown to be a straight line. That is, the via 50 may tapper from the top portion to the bottom portion. As shown in FIG. 5 and FIG. 6, the upper sidewall of the via 50 may have a curved shape. That is, in the top portion of the via 50, the via 50 may have a curved shape which reduces a width of the via 50 away from the upper conductive line Mb1.

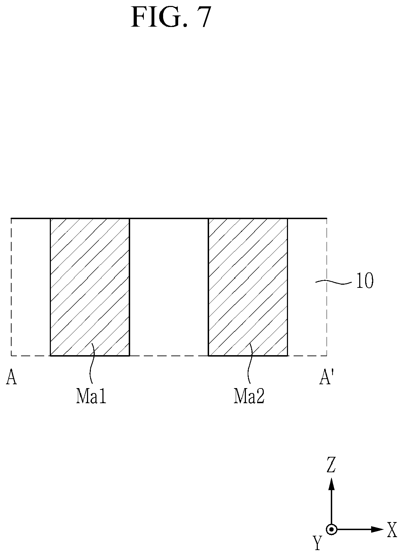

FIG. 7 to FIG. 21 show cross-sectional views illustrating a method for manufacturing a semiconductor device described with reference to FIG. 1 to FIG. 6.

For better understanding and ease of description, a process for manufacturing a via for connecting conductive lines disposed on two layers according to some embodiments is described in detail. Embodiments of a method for manufacturing a semiconductor device may be used to connect conductive lines formed on at least three layers.

FIG. 7 to FIG. 21 show regions that correspond to a cross-section with respect to the line A-A' of FIG. 1 or FIG. 4. FIG. 7 to FIG. 21 illustrate a method for manufacturing a semiconductor device according to some embodiments.

Referring to FIG. 7, the first lower conductive line Ma1 and the second lower conductive line Ma2 may be formed on a substrate (not shown). FIG. 7 shows part of the first interlayer insulating layer 10.

In detail, the first interlayer insulating layer 10 is formed on the substrate and part of the first interlayer insulating layer 10 may be removed to form first trenches.

In some embodiments, the first trenches may be formed on an upper portion of the first interlayer insulating layer 10 by removing part of the first interlayer insulating layer 10. In other embodiments, the first trenches may be formed to pass through the first interlayer insulating layer 10. In this case, the first trenches may expose an upper side of an element formed on the lower portion of the first interlayer insulating layer 10. The first trenches may expose an upper side of an element formed below the first interlayer insulating layer 10.

The first lower conductive line Ma1 and the second lower conductive line Ma2 may be formed filling the first trenches. When the first trenches are formed to pass through the first interlayer insulating layer 10, the first lower conductive line Ma1 and the second lower conductive line Ma2 may contact the element on the lower portion of the first interlayer insulating layer 10 and may be electrically connected to the element.

The first lower conductive line Ma1 and the second lower conductive line Ma2 may include a first barrier metal pattern (not shown) and a first metal pattern (not shown) that may be sequentially accumulated. In some embodiments, the first barrier metal pattern may be conformally formed on an interior wall of the first trench and a bottom side of the first trench, and the first metal pattern may be formed on the first barrier metal pattern to fill the first trench. In other embodiments, the first barrier metal pattern may be conformally formed on the interior wall of the first trench and the upper side of the element exposed by the first trench, and the first metal pattern may be formed on the first barrier metal pattern to fill the first trench. In some embodiments, a first metal capping pattern may be additionally disposed on the upper side of the first metal pattern.

The first lower conductive line Ma1 and the second lower conductive line Ma2 may be formed by conformally forming the first barrier metal layer on the inside of the first trenches and the upper side of the first interlayer insulating layer 10, forming a first metal layer for filling the first trenches in the first barrier metal layer, and planarizing the first barrier metal layer and the first metal layer at least until the first interlayer insulating layer 10 is exposed.

The planarization process may include, for example, a chemical mechanical polishing (CMP) process and/or an etch back process.

Referring to FIG. 8, the first lower conductive line Ma1 and second lower conductive line Ma2 may be partially exposed by recessing the first interlayer insulating layer 10. The first interlayer insulating layer 10 may be recessed so that part of the sidewalls of the first lower conductive line Ma1 and second lower conductive line Ma2 may be exposed. For example, the first interlayer insulating layer 10 may be recessed by a reactive ion etching (RIE) process. The first lower conductive line Ma1 and second lower conductive line Ma2 may not be substantially changed and remain following the RIE process. Although not shown, in some embodiments, upper corners of the first lower conductive line Ma1 and second lower conductive line Ma2 may be rounded for the RIE process. These corners may be disposed between the upper sides and the sidewalls of the first lower conductive line Ma1 and second lower conductive line Ma2.

The first interlayer insulating layer 10 may be recessed, as described herein, so that the protrusions of the first lower conductive line Ma1 and second lower conductive line Ma2 may have a predetermined height.

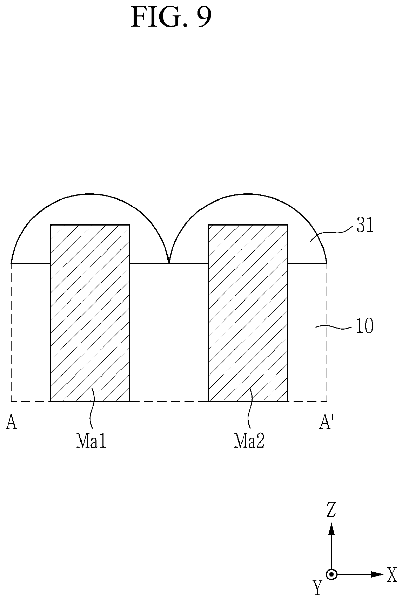

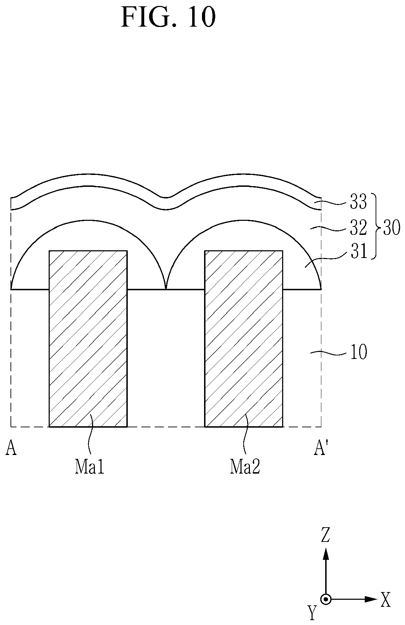

Referring to FIG. 9 and FIG. 10, the etch stop layer 30 may be formed to cover the protrusions of the first lower conductive line Ma1 and second lower conductive line Ma2. The etch stop layer 30 may be configured with at least two etch stop layers. In detail, the etch stop layer 30 may include the first etch stop layer 31 and the second etch stop layer 32 disposed on the first etch stop layer 31. The first etch stop layer 31 may have a curved shape. The second etch stop layer 32 may have a thickness variation.

In some embodiments, as shown in FIG. 10, the etch stop layer 30 may include the first etch stop layer 31 covering the protrusions of the first lower conductive line Ma1 and second lower conductive line Ma2 and having a curved shape, the second etch stop layer 32 disposed on the first etch stop layer 31 and having a thickness variation, and the third etch stop layer 33 disposed on the second etch stop layer 32.

A method for forming the first etch stop layer 31 is factor for determining the shape of the first etch stop layer 31.

The first etch stop layer 31 may be formed to have low conformality according to a chemical vapor deposition (CVD) process with fast deposition rates, a physical vapor deposition (PVD) sputtering process, or a selective deposition process (e.g., a selective ALD). That is, the first etch stop layer 31 may have low conformality and may be formed to be uneven on the upper sides of the first lower conductive line Ma1 and second lower conductive line Ma2.

In an example case where a method of manufacturing a semiconductor device includes disposing an insulation pattern on a first interlayer insulating layer between lower conductive lines for increasing the electrical short circuit margin between a via and an adjacent lower conductive line, the insulation pattern must be selectively formed, with very high selectivity, on the first interlayer insulating layer between the lower conductive lines. However, according to some embodiments, the method for manufacturing a semiconductor device may include forming the first etch stop layer 31 in a curved shape according to a deposition with low conformality, which does not require the high level of selectivity.

As described above, the upper corners of the first lower conductive line Ma1 and second lower conductive line Ma2 may be rounded by a process for recessing the first interlayer insulating layer 10. In a case where the protrusions of the first lower conductive line Ma1 and second lower conductive line Ma2 have rounded corners, the first etch stop layer 31 may be more easily manufactured to have a curved shape.

Referring to FIG. 10, the second etch stop layer 32 may be formed on the first etch stop layer 31. The second etch stop layer 32 may have a thickness variation according to the profile of the first etch stop layer 31.

The average thickness of the second etch stop layer 32 may be greater than the average thickness of the first etch stop layer 31.

The second etch stop layer 32 may be formed by, for example, an atomic layer deposition (ALD) process, a chemical vapor deposition (CVD) process, or a physical vapor deposition (PVD) process.

Referring to FIG. 10, the third etch stop layer 33 may be formed on the second etch stop layer 32. The third etch stop layer 33 may be formed according to the profile of the second etch stop layer 32. An average thickness of the third etch stop layer 33 may be formed to be less than an average thickness of the second etch stop layer 32. The third etch stop layer 33 may be formed by, for example, the atomic layer deposition (ALD) process, the chemical vapor deposition (CVD) process, or the physical vapor deposition (PVD) process.

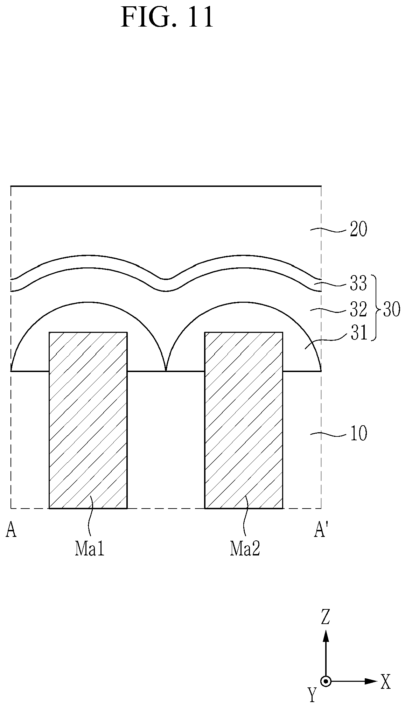

Referring to FIG. 11, the second interlayer insulating layer 20 may be formed on the etch stop layer 30. The second etch stop layer 32 may be etched for a TCR process of the second interlayer insulating layer 20. Hence, the second interlayer insulating layer 20 may include a material having a low etch selectivity ratio with that of the second etch stop layer 32.

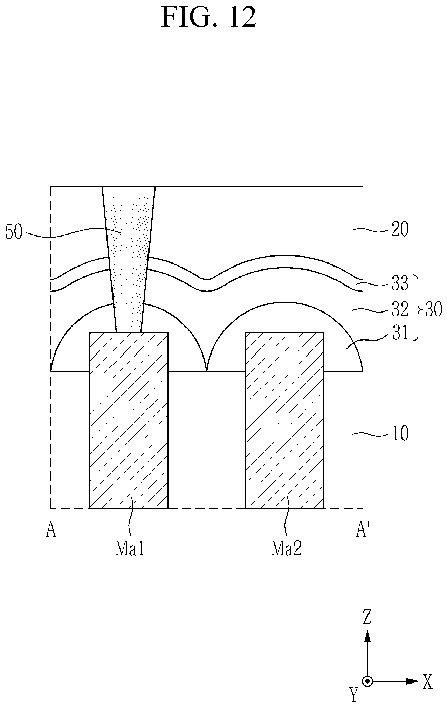

Referring to FIG. 12, a via 50 passing through the second interlayer insulating layer 20 and the etch stop layer 30 and connected to the first lower conductive line Ma1 may be formed. Although the via 50 is shown to be formed alone in FIG. 12, the via 50 and the upper conductive line Mb1 may be simultaneously formed by, for example, a dual damascene process. By this, the via 50 and the upper conductive line Mb1 may be integrally formed.

Referring to FIG. 2 and FIG. 12, to form the via 50 and the upper conductive line Mb1, a via hole passing through the second interlayer insulating layer 20 and the etch stop layer 30 and exposing an upper side of the first lower conductive line Ma1 may be formed. In some embodiments, a second trench passing through an upper portion of the second interlayer insulating layer 20 and connected to the via hole may be formed, where the second trench may be formed for the upper conductive line Mb1. A second barrier metal layer may be conformally formed on an interior wall of the via hole, an exposed portion of the upper side of the first lower conductive line Ma1, an interior wall and a bottom side of the second trench, and an upper side of the second interlayer insulating layer 20, a second metal layer filling the via hole and the second trench may be formed on the second barrier metal layer, and the second barrier metal layer and the second metal layer may be planarized at least until the second interlayer insulating layer 20 is exposed. As a result, the second metal pattern filling the via hole and the second barrier metal pattern portion covering the second metal pattern may form the via 50, and the second metal pattern filling the second trench and the second barrier metal pattern portion covering the same may form the upper conductive line Mb1.

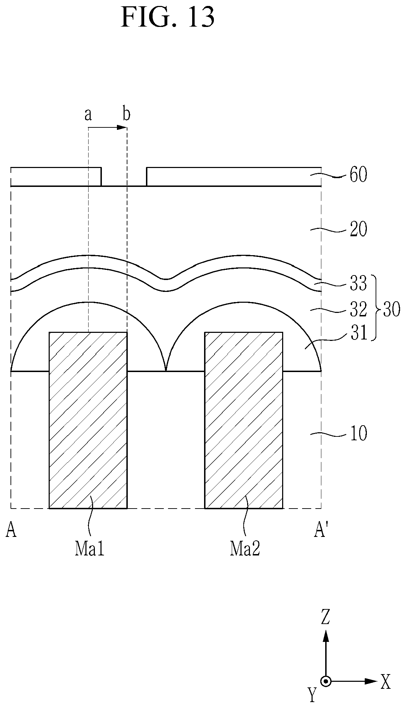

As shown in FIG. 13, a mask 60 having an opening that corresponds to the via hole (marked as T1 in FIG. 14) may be misaligned with the first lower conductive line Ma1. For example, the via hole may be misaligned due to overlay errors. FIG. 13 shows an example in which a center axis (marked as b) of the opening of the mask 60 is disposed to the X direction from a center axis (marked as a) of the first lower conductive line Ma1.

Referring to FIG. 14, the via hole T1 passing through the second interlayer insulating layer 20 may be misaligned with the first lower conductive line Ma1 due to the misalignment of the mask 60.

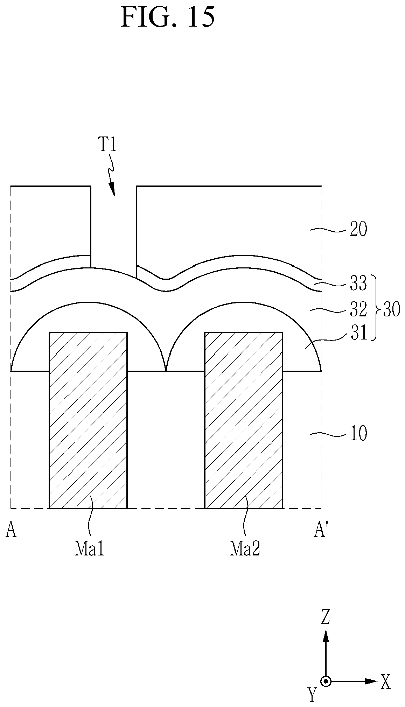

Referring to FIG. 15, the third etch stop layer 33 may be etched, and the via hole T1 may pass through the second interlayer insulating layer 20 and may extend to the upper side of the second etch stop layer 32.

Referring to FIG. 16, a top corner rounding (TCR) process may be performed on the second interlayer insulating layer 20. An upper corner region of the via hole T1 may be rounded according to the TCR process. Although not shown, when the second trench that corresponds to the upper conductive line Mb1 and is connected to the via hole T1 is formed, the upper corner region of the second trench may be rounded by the TCR process. It should be understood that the second trench that corresponds to the upper conductive line Mb1 extends in the X direction, perpendicular to the via hole T1 (see FIG. 2).

Referring to FIG. 16, during the TCR process, the second etch stop layer 32 may be etched. The second etch stop layer 32 may have a relatively low etch selectivity with respect to the second interlayer insulating layer 20. In this instance, the first portion of the second etch stop layer 32 overlapping the first lower conductive line Ma1 in the direction (Z direction) that is perpendicular to the substrate may be relatively thin, and the second portion of the second etch stop layer 32 overlapping the first interlayer insulating layer 10 in the direction (Z direction) that is perpendicular to the substrate may be relatively thick, and when the first portion of the second etch stop layer 32 is etched and the first etch stop layer 31 is exposed, the process (TCR process) for etching the second etch stop layer 32 may not exposed at least a portion of the first etch stop layer 31 through the second portion of the second etch stop layer 32.

Referring to FIG. 17, when the first etch stop layer 31 exposed after the second etch stop layer 32 is etched, the first etch stop layer 31 overlapping the first interlayer insulating layer 10 in the direction (Z direction) that is perpendicular to the substrate may be protected by the second portion of the second etch stop layer 32. With the first etch stop layer 31 overlapping the first interlayer insulating layer 10 in the direction (Z direction) that is perpendicular to the substrate protected by the second portion of the second etch stop layer 32, the first etch stop layer 31 overlapping the first lower conductive line Ma1 in the direction (Z direction) that is perpendicular to the substrate may be selectively etched.

Referring to FIG. 18, the self-aligned via 50 may be manufactured by forming the second barrier metal pattern and the second metal pattern in the via hole T1 in which the upper side of the first lower conductive line Ma1 may be exposed.

Referring to FIG. 19, in some embodiments, the second portion of the second etch stop layer 32 may be etched and the first etch stop layer 31 may be exposed. In this case, as shown in FIG. 20, the first etch stop layer 31 overlapping the first lower conductive line Ma1 in the direction (Z direction) that is perpendicular to the substrate is thinner than the first etch stop layer 31 overlapping the first interlayer insulating layer 10 in the direction (Z direction) that is perpendicular to the substrate. Given the various thicknesses of the first etch stop layer 31, the upper side of the first lower conductive line Ma1 may be exposed before the via hole T1 contacts the first interlayer insulating layer 10. In this case, the portion of the first etch stop layer 31 on a side of first lower conductive line Ma1 among the portion of the first etch stop layer 31 overlapping the first interlayer insulating layer 10 in the direction (Z direction) that is perpendicular to the substrate may be thicker than the portion of the first etch stop layer 31 overlapping the first lower conductive line Ma1 in the direction (Z direction) that is perpendicular to the substrate. Accordingly, as shown in FIG. 21, the self-aligned via 50 may be manufactured by forming the second barrier metal pattern and the second metal pattern in the via hole T1 in which the upper side and partial lateral side of the first lower conductive line Ma1 may be exposed.

While this disclosure has been described in connection with what is presently considered to be practical embodiments, it is to be understood that the invention is not limited to disclosed embodiments, and the disclosure is intended to cover various modifications and equivalent arrangements included within the scope of the appended claims.

## Claims

1. A semiconductor device comprising:
a first interlayer insulating layer disposed on a substrate;
a first conductive line disposed in the first interlayer insulating layer and having a protrusion protruding above an upper side of the first interlayer insulating layer;
an etch stop layer disposed on the first interlayer insulating layer and the first conductive line; and
a via passing through the etch stop layer and contacting the first conductive line,
wherein the etch stop layer includes a first etch stop layer having a curved shape in a cross-sectional view and a second etch stop layer disposed on the first etch stop layer and having a thickness variation.

2. The semiconductor device of claim 1, wherein the protrusion of the first conductive line has a height between about 1 to 10 nanometers above the upper side of the first interlayer insulating layer.

3. The semiconductor device of claim 1 or 2, wherein a height of the first etch stop layer gradually increases toward a central portion of the first conductive line.

4. The semiconductor device of claim 1, 2 or 3, wherein the first etch stop layer has a radius of curvature of about 8 to 48 nanometers.

5. The semiconductor device of any one of claims 1 to 4, wherein an average thickness of the second etch stop layer is greater than an average thickness of the first etch stop layer.

6. The semiconductor device of any one of claims 1 to 5, wherein a first portion of the second etch stop layer overlapping the first interlayer insulating layer in a direction that is perpendicular to the substrate is thicker than a second portion of the second etch stop layer overlapping the first conductive line in the direction that is perpendicular to the substrate.

7. The semiconductor device of any one of claims 1 to 6, wherein the via does not pass through a portion of the first etch stop layer overlapping the first interlayer insulating layer in a direction that is perpendicular to the substrate.

8. The semiconductor device of any one of claims 1 to 7, wherein the via is disposed above and does not pass through a portion of the first etch stop layer overlapping the first interlayer insulating layer in a direction that is perpendicular to the substrate.

9. A method for manufacturing a semiconductor device comprising:
forming a first conductive line in a first interlayer insulating layer;
recessing the first interlayer insulating layer to form a protrusion of the first conductive line protruding above an upper side of the first interlayer insulating layer;
forming a first etch stop layer in a curved shape to cover the first interlayer insulating layer and the protrusion of the first conductive line;
forming a second etch stop layer with a thickness variation on the first etch stop layer; and
forming a via passing through the first etch stop layer and the second etch stop layer.

10. The method of claim 9, wherein the first etch stop layer is formed by a chemical vapor deposition process, a physical vapor deposition sputtering process, or a selective deposition process.

11. The method of claim 9 or 10, further comprising forming a second interlayer insulating layer on the second etch stop layer.

12. The method of claim 11, wherein the forming of the via comprises:
etching the second etch stop layer; and
a top corner rounding process for rounding a corner of the second interlayer insulating layer.

13. The method of any one of claims 9 to 12, wherein the forming of the second etch stop layer includes forming a first portion of the second etch stop layer overlapping the first interlayer insulating layer and a second portion of the second etch stop layer overlapping the first conductive line, wherein the first portion is thicker than the second portion.

14. The method of claim 13, wherein the forming of the via includes ending a process for etching the second etch stop layer when the second portion of the second etch stop layer overlapping the first conductive line is etched and the first etch stop layer is exposed.

15. The method of claim 13 or 14, wherein the forming of the via includes ending a process for etching the second etch stop layer while at least a portion of the first portion of the second etch stop layer overlapping the first interlayer insulating layer and disposed below the via remains when the second portion of the second etch stop layer overlapping the first conductive line is etched and the first etch stop layer is exposed.

## Amended claims

### Amended claims in accordance with Rule 137(2) EPC.

1. A semiconductor device comprising:
a first interlayer insulating layer (10) disposed on a substrate;
a first conductive line (Ma1) disposed in the first interlayer insulating layer (10) and having a protrusion protruding above an upper side of the first interlayer insulating layer (10);
an etch stop layer (30) disposed on the first interlayer insulating layer (10) and the first conductive line (Ma1);
a second interlayer insulating layer (20) disposed on the etch stop layer (30); and
a via passing through the second interlayer insulating layer (20) and the etch stop layer (30) and contacting the first conductive line (Ma1),
**characterized in that** the etch stop layer (30) includes a first etch stop layer (31) having a curved shape in a cross-sectional view and a second etch stop layer (32) disposed on the first etch stop layer (31) and having a thickness variation.

2. The semiconductor device of claim 1, wherein the protrusion of the first conductive line (Ma1) has a height between about 1 to 10 nanometers above the upper side of the first interlayer insulating layer (10).

3. The semiconductor device of claim 1 or 2, wherein a height of the first etch stop layer (31) gradually increases toward a central portion of the first conductive line (Ma1).

4. The semiconductor device of claim 1, 2 or 3, wherein the first etch stop layer (31) has a radius of curvature of about 8 to 48 nanometers.

5. The semiconductor device of any one of claims 1 to 4, wherein an average thickness of the second etch stop layer (32) is greater than an average thickness of the first etch stop layer (31).

6. The semiconductor device of any one of claims 1 to 5, wherein a first portion of the second etch stop layer (32) overlapping the first interlayer insulating layer (10) in a direction that is perpendicular to the substrate is thicker than a second portion of the second etch stop layer (32) overlapping the first conductive line (Ma1) in the direction that is perpendicular to the substrate.

7. The semiconductor device of any one of claims 1 to 6, wherein the via does not pass through a portion of the first etch stop layer (31) overlapping the first interlayer insulating layer (10) in a direction that is perpendicular to the substrate.

8. The semiconductor device of any one of claims 1 to 7, wherein the via is disposed above and does not pass through a portion of the first etch stop layer (31) overlapping the first interlayer insulating layer (10) in a direction that is perpendicular to the substrate.

9. A method for manufacturing a semiconductor device comprising:
forming a first conductive line (Ma1) in a first interlayer insulating layer (10);
recessing the first interlayer insulating layer (10) to form a protrusion of the first conductive line (Ma1) protruding above an upper side of the first interlayer insulating layer (10);
forming a first etch stop layer (31) in a curved shape to cover the first interlayer insulating layer (10) and the protrusion of the first conductive line (Ma1);
forming a second etch stop layer (32) with a thickness variation on the first etch stop layer (31);
forming a second interlayer insulating layer (20) on the etch stop layer (30);and
forming a via passing through the second interlayer insulating layer (20), the first etch stop layer (31), and the second etch stop layer (32).

10. The method of claim 9, wherein the first etch stop layer (31) is formed by a chemical vapor deposition process, a physical vapor deposition sputtering process, or a selective deposition process.

11. The method of claim 9 or 10, wherein the forming of the via comprises:
etching the second etch stop layer (32); and
a top corner rounding process for rounding a corner of the second interlayer insulating layer.

12. The method of any one of claims 9 to 11, wherein the forming of the second etch stop layer (32) includes forming a first portion of the second etch stop layer (32) overlapping the first interlayer insulating layer (10) and a second portion of the second etch stop layer (32) overlapping the first conductive line (Ma1), wherein the first portion is thicker than the second portion.

13. The method of claim 12, wherein the forming of the via includes ending a process for etching the second etch stop layer (32) when the second portion of the second etch stop layer (32) overlapping the first conductive line (Ma1) is etched and the first etch stop layer (31) is exposed.

14. The method of claim 12 or 13, wherein the forming of the via includes ending a process for etching the second etch stop layer (32) while at least a portion of the first portion of the second etch stop layer (32) overlapping the first interlayer insulating layer (10) and disposed below the via remains when the second portion of the second etch stop layer (32) overlapping the first conductive line (Ma1) is etched and the first etch stop layer (31) is exposed.
